Europäisches Patentamt

European Patent Office

Office européen des brevets

(11) Publication number: **0 378 077**
**A2**

## (12) EUROPEAN PATENT APPLICATION

(21) Application number: **90100044.8**

(22) Date of filing: **02.01.90**

(51) Int. Cl.5: **H01J 49/04, H01J 37/256**

(30) Priority: **09.01.89 JP 1318/89**

(43) Date of publication of application:
**18.07.90 Bulletin 90/29**

(84) Designated Contracting States:
**DE GB**

(71) Applicant: **HITACHI, LTD.**
**6, Kanda Surugadai 4-chome**
**Chiyoda-ku, Tokyo 100(JP)**

(72) Inventor: **Izumi, Eiichi**
**953, Takado**
**Takahagi-shi(JP)**
Inventor: **Taya, Shunroku**
**1825-109, Hirasucho**
**Mito-shi(JP)**

(74) Representative: **Strehl, Schübel-Hopf,**
**Groening**
**Maximilianstrasse 54 Postfach 22 14 55**
**D-8000 München 22(DE)**

(54) **Ion mass-spectroscopic analysis method and apparatus.**

(57) An ion mass-spectroscopic analysis method and apparatus are disclosed in which a specimen (5) is subjected to a small movement in a predetermined direction and a primary ion beam (2) to be impinged upon the specimen is repeatedly deflected so as to scan the specimen with the primary ion beam in a direction perpendicular to the direction of movement of the specimen. Secondary ions (7) generated from the specimen through the movement of the specimen and the scanning of the specimen with the primary ion beam are detected and mass-analyzed.

F I G. 3

# ION MASS-SPECTROSCOPIC ANALYSIS METHOD AND APPARATUS

## BACKGROUND OF THE INVENTION

The present invention relates to an ion mass-spectroscopic analysis method and apparatus, and more particularly to an ion mass-spectroscopic analysis method and apparatus suitable for mass-spectroscopic analysis of secondary ions generated from a specimen by bombardment of the specimen with primary ions or neutral particles.

In apparatus for making a mass-spectroscopic analysis of secondary ions generated from a specimen by bombardment of the specimen with an ion beam or neutral particle beam (primary beam), there is known one technology by which the element concentration distribution or profile of the specimen in a direction of depth thereof is measured with a high precision (see, for example, U.S. Patent No. 3,881,108). This technology is generally called an electronic aperture method. According to the electronic aperture method, the specimen is two-dimensionally scanned with a primary beam and only secondary ions generated from a limited central region of a scanned area of the specimen among secondary ions generated from the scanned area, are used as data for mass-spectroscopic analysis. In principle, therefore, the electronic aperture method permits the analysis of the specimen in the depth direction with a high precision.

However, it has been found out that when the specimen is scanned with a primary beam over a relatively wide area thereof larger than several hundred microns in accordance with the electronic aperture method, the efficiency of collection of secondary ions and hence the detection sensitivity are deteriorated at a portion distanced from a central portion of the scanned area, as will be mentioned in later.

## SUMMARY OF THE INVENTION

An object of the present invention is to provide an ion mass-spectroscopic analysis method and apparatus which are capable of making substantially uniform the efficiency of collection of secondary ions derived from a two-dimensional area of a specimen.

Another object of the present invention is to provide an ion mass-spectroscopic analysis method and apparatus suitable for prevention or reduction of the deterioration of the efficiency of collection of secondary ions at that portion of a two-dimensional area which is distanced from a central portion of the two-dimensional area.

According to the present invention, one of a specimen and a primary beam with which the specimen is to be bombarded is moved relative to the other thereof in a first direction while the other is moved relative to the one in a second direction substantially perpendicular to the first direction.

With the above-mentioned construction of the present invention, the conventionally conducted scanning of the specimen by the primary beam in a direction in which the uniformity of the efficiency of collection of secondary ions is poor can be substituted by the movement of the specimen. Since it is not necessary to move the primary beam in that direction, there is eliminated a fear that the uniformity of the efficiency of collection of secondary ions may be deteriorated in that direction. Accordingly, the efficiency of collection of secondary ions is made substantially uniform over the whole of a two-dimentional area where secondary ions are to be generated.

The above and other objects and features of the present invention will become apparent from the following description made in reference with the accompanying drawings.

## BRIEF DESCRIPTION OF THE DRAWINGS

Fig. 1a is a view which is useful in explaining the known electronic aperture technology and shows a relationship between a specimen and a primary beam to scan the specimen;

Fig. 1b is a cross-section of Fig. 1a;

Fig. 2a is a view illustrating the shape of the known object point slit;

Figs. 2b and 2c are graphs showing secondary-ion intensity characteristics in the conventional method;

Fig. 3 is a diagram for explaining the principle of an embodiment of an ion mass-spectroscopic analysis apparatus based on the present invention;

Fig. 4 is a block diagram of an embodiment of an electric circuit system of the ion mass-spectroscopic analysis apparatus based on the present invention;

Fig. 5 is a block diagram of an electric circuit system of the conventional ion mass-spectroscopic analysis apparatus;

Fig. 6a is a view illustrating the shape of an object point slit shown in Fig. 3;

Fig. 6b is a view showing a relationship between a specimen and a primary beam to scan the specimen in an embodiment of the present invention; and

Figs. 6c and 6d are graphs showing secondary-ion intensity characteristics obtained by the embodiment of the present invention.

## DESCRIPTION OF THE PREFERRED EMBODIMENTS

Prior to explanation of an embodiment of the present invention, the known electronic aperture method will be explained.

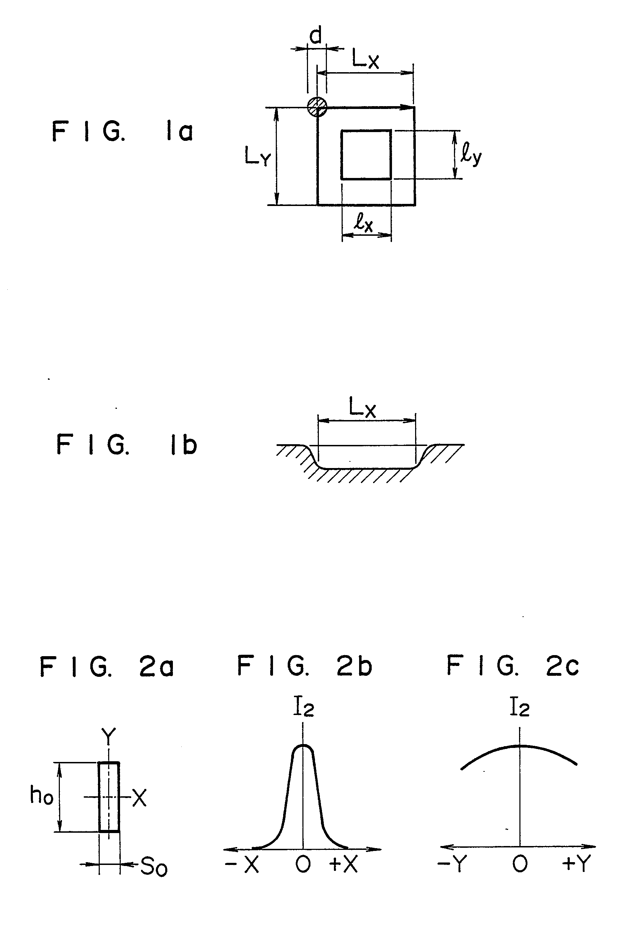

As shown in Fig. 1a, a specimen is raster-scanned with a primary beam of diameter $d$ by $L_X$ in an X direction and by $L_Y$ in a Y direction. In other words, the primary beam is moved on the specimen by $L_X$ in the X direction and by $L_Y$ in the Y direction. The raster scan causes the substantially uniform sputtering of the specimen by the primary beam, as shown in Fig. 1b. According to the principle of the electronic aperture method, only secondary ions emitted from a central region of $l_X \times l_Y$ of the raster-scanned area $L_X \times L_Y$ are collected as data for mass-spectroscopic analysis, thereby permitting the analysis of the specimen in a direction of depth thereof with a high precision.

However, there has been found out a problem that when the scanning is made over a relatively wide area larger than several hundred microns in accordance with the electronic aperture method, the efficiency of collection of secondary ions from a region distanced from a central portion of the scanned area is deteriorated and hence the detection sensitivity is lowered. This will now be explained by virtue of Figs. 2a to 2c. Fig. 2a shows the shape of an object point slit in an apparatus for mass-spectroscopic analysis of secondary ions. In Fig. 2a, an X direction coincides with a direction of mass dispersion or scattering of secondary ions by a magnetic field in the mass-spectroscopic analysis apparatus. Fig. 2b shows a change of the intensity $I_2$ of secondary ions when the primary beam is moved in the X direction or direction of width $S_0$ of the object point slit and Fig. 2c shows a change of the intensity $I_2$ of secondary ions when the primary beam is moved in the Y direction or direction of height $h_0$ of the object point slit. Data shown in Figs. 2b and 2c are data obtained in the case where the element concentration of the sample is constant in each of the X and Y directions. From the figures, it can be seen that the intensity of secondary ions is remarkable or high in the X direction. This tendency becomes more remarkable as the width $S_0$ of the object point slit is made narrow. As a result, in the case where the element concentration distribution image of the two-dimensional area of the specimen is obtained, there arises a problem that the image is bright at a central portion thereof and dark at a peripheral portion thereof.

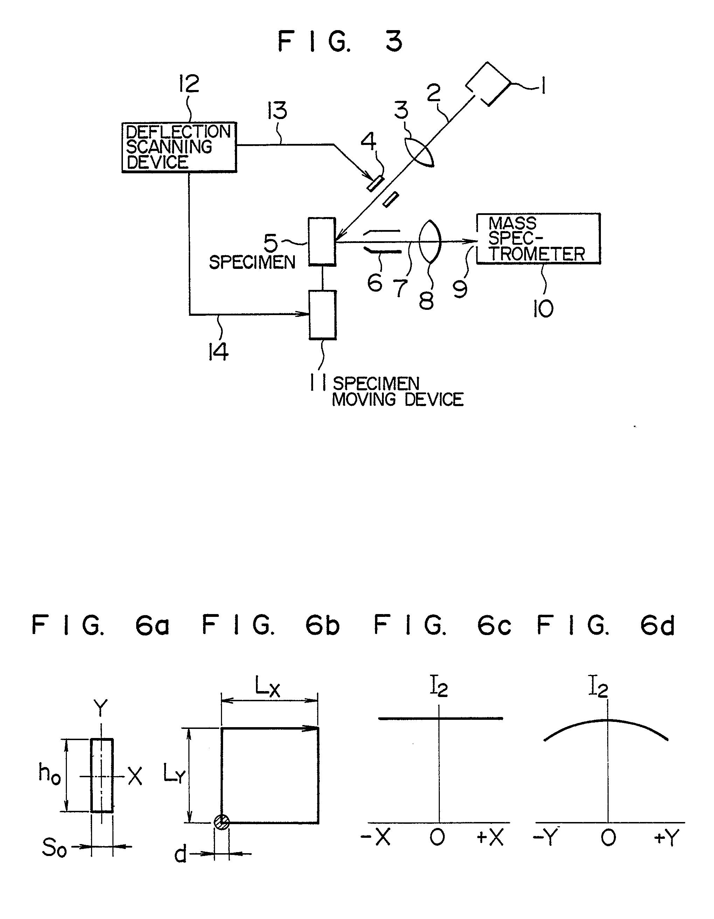

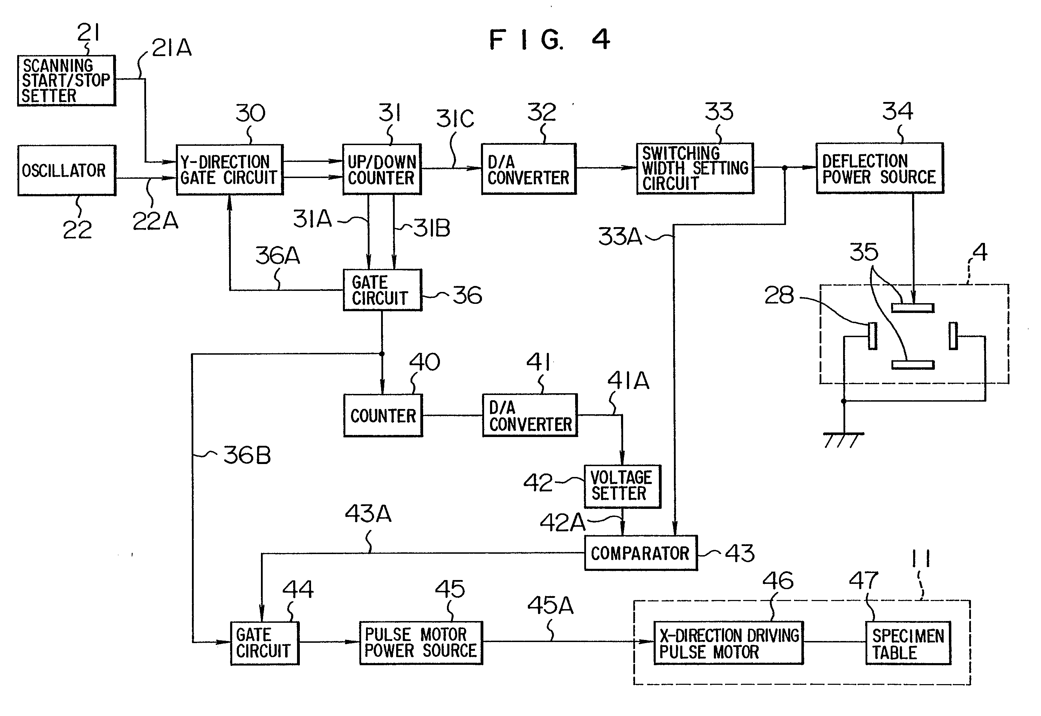

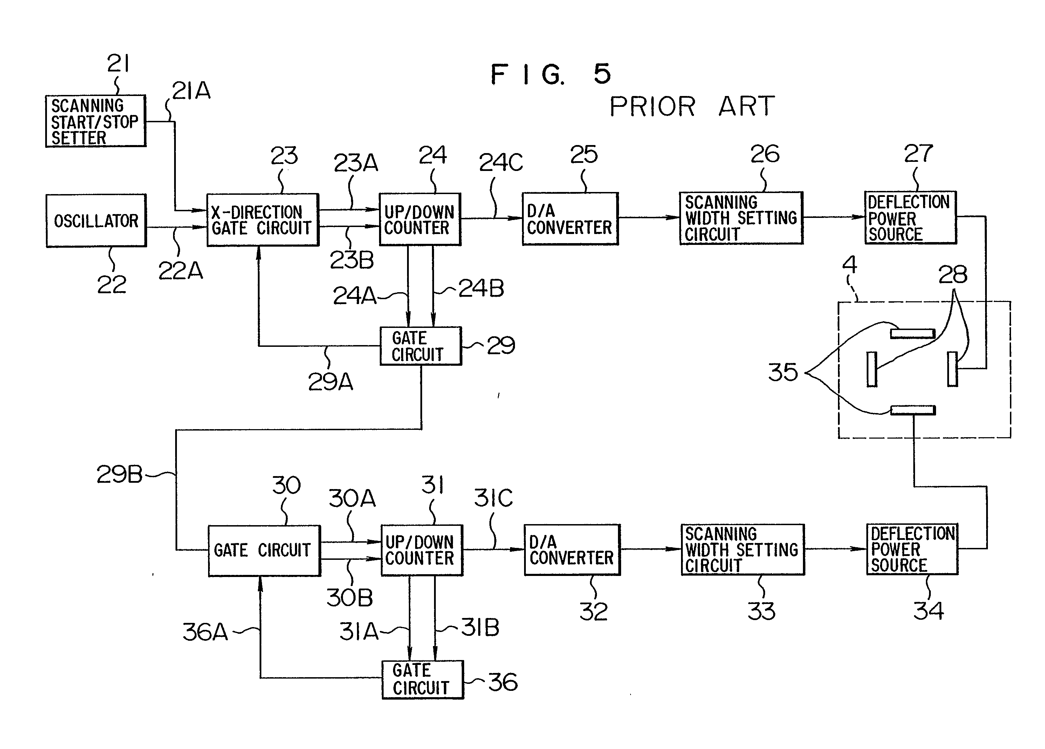

An embodiment of the present invention will now be explained by virtue of Fig. 3.

Referring to Fig. 3, a primary ion beam 2 generated and accelerated by an ion source 1 is impinged upon a specimen 5 through a lens system 3 and a deflector 4. The primary beam may be a high-speed neutral particle beam. Secondary ions 7 emitted from the specimen 5 are extracted by an entracting electrode 6 and are focused onto an object point slit 9 by a lens 8. The secondary ions emerging from the slit 9 are introduced into a mass spectrometer 10 for mass-spectroscopic analysis thereof. The mass spectrometer 10 includes a magnet which generates a magnetic field for mass dispersion. In many cases, the mass spectrometer 10 further includes an electrode which generates an electric field for velocity dispersion. Secondary ions double-focused by the electric field and the magnetic field are detected by a detector. On the other hand, a deflection scanning device 12 is connected with the beam deflector 4 for primary ion beam and a specimen moving device 11 which gives a small movement to the specimen 5. The deflection scanning device 12 supplies a deflection control signal 13 and a specimen movement control signal 14 to the deflector 4 and the specimen moving device 11, respectively. In general, a parallel-plate type electrostatic deflector is used as the deflector 4 for primary ion beam.

When the primary ion beam accelerated with an accelerating voltage $V_a$ is deflected by $d_1$ on the specimen, a voltage $V_d$ applied to the electrostatic deflector and the amount $d_1$ of deflection satisfy the equation of

$$d_1 = K_1 \cdot V_d / V_a \qquad (1)$$

where $K_1$ is a constant determined by the dimension of the deflector.

On the other hand, a pulse motor is used as a driver source for the specimen moving device. In this case, the amount $d_2$ of small movement of the specimen and the number $N_P$ of pulses satisfy the equation of

$$d_2 = K_2 \cdot N_P \qquad (2)$$

where $K_2$ is the amount of small movement per one pulse which is given to the specimen by the specimen moving device driven by the pulse motor. In the case where the specimen moving device is designed so as to provide $K_2 = 1 \ \mu m/pulse$, the number of pulses corresponds to the amount of small movement in units of one micron.

In the case where the analysis in a depth direction is to be made in a secondary-ion mass spectrometry, it is preferable that each of the value of $d_1$ in the equation (1) and the value of $d_2$ in the equation (2) is variable. The value of $d_1$ may be changed by the voltage $V_d$ applied to the deflector and the value of $d_2$ may be changed by the number $N_P$ of pulses. In the case where $d_1$ and $d_2$ are made equal to each other, it is preferable to make

$N_P$ proportional to $V_d$ on the basis of the equations (1) and (2), as represented by the following equation (3):

$$N_P = K_1 \cdot V_d / K_2 \cdot V_a = K_3 \cdot V_d \qquad (3)$$

In general, an electrical scanning time is several ten to several thousand milliseconds per one frame. Provided that the number of scanning lines or the number of movement steps of the specimen in the X direction is 100, a time per one step for scanning in the Y direction is 0.1 to several ten milliseconds. On the other hand, since the response of the pulse motor is 250 to 1000 pulse/sec, a time per one pulse is 1 to 4 msec.

The deflection scanning device 12 should be implemented taking account of the above-mentioned features of the electrical scanning or the scanning of the specimen by the primary ion beam and the mechanical scanning or the movement of the specimen.

Fig. 4 shows an embodiment of the deflection scanning device 12 according to the present invention. Prior to explanation of Fig. 4, one example of the conventional electrical scanning method will be explained by virtue of Fig. 5.

Referring to Fig. 5, when a scanning start signal 21A is issued from a scanning start/stop setter 21, an X-direction gate circuit 23 operates to input pulses 22A from an oscillator 22 to an up-count input terminal of an up/down counter 24. The count value 24C of the up/down counter 24 is converted into an analog value by a D/A converter 25. This analog value is set to a voltage value conformable to a scanning width by a scanning width setting circuit 26. This voltage value is inputted to a deflection power source 27 which in turn outputs a deflection voltage to be applied to a deflector 28 for X direction of a primary-ion deflecting device 4.

When the count value of the up/down counter 24 reaches a saturated value, the counter 24 outputs a carry signal (or single-scanning end signal) 24A. Upon reception of the carry signal 24A, a gate circuit 29 sends a state signal 29A to the gate circuit 23. The gate circuit 23 inputs pulses 23B to a down-count input terminal of the counter 24. Thereby, the saturated count value of the counter 24 is decremented one by one. When the count value of the counter 24 becomes zero, the counter 24 outputs a borrow signal (or single-scanning end signal) 24B so that the gate circuit 29 and the gate circuit 23 operate to turn the counter 24 into a count-up condition. Thus, the scanning in the X direction assumes a triangular scanning.

On the other hand, the gate circuit 29 sends the carry signal 24A and the borrow signal 24B as an input pulse signal 29B to a gate circuit 30 of a Y scanning circuit. The gate circuit 30 sends pulses 30A to an up-count input terminal of an up/down counter 31. Like the case of the scanning in the X direction, the count value 31C of the counter 31 is converted into an analog value by a D/A converter 32 and the analog value is set to a voltage value conformable of a scanning width by a scanning width setting circuit 33. This voltage value is inputted to a deflection power source 34 which in turn applies a deflection voltage to a deflector 35 for Y direction.

When the count value of the up/down counter 31 reaches a saturated value, the counter 31 outputs a carry signal (or single-scanning end signal) 31A. Upon reception of the carry signal 31A, a gate circuit 36 sends a state signal 36A to the gate circuit 30. The gate circuit 30 inputs pulses 30B to a down-count terminal of the counter 31. Thereby, the saturated count value of the counter 31 is decremented one by one. When the count value of the counter 31 becomes zero, the counter 31 outputs a borrow signal (or single-scanning end signal) 31B so that the gate circuit 36 and the gate circuit 30 operate to turn the counter 31 into a count-up condition. Thus, the scanning in the Y direction assumes a triangular scanning.

In the above-mentioned deflection scanning device, it is possible to easily set scanning widths by interlocking the X-direction and Y-direction scanning width setting circuits 26 and 33 with each other. Also, the device can sufficiently cope with the above-mentioned scanning time.

In embodiment of a deflection scanning device for the combined scanning of electrical scanning and mechanical scanning according to the present invention will now be explained by virtue of Fig. 4.

Referring to Fig. 4, when a scanning start signal 21A is issued from a scanning start/stop setter 21, a Y-direction gate circuit 30 operates input pulses 22A from an oscillator 22 to an up-count input terminal of an up/down counter 31. The count value 31C of the up/down counter 31 is converted into an analog value by a D/A converter 32. This analog value is set to a voltage value conformable to a scanning width by a scanning width setting circuit 33. This voltage value is inputted to a deflection power source 34 which in turn applies an output deflection voltage to a deflecting electrode 35 for Y direction of a primary-ion deflection device 4. A deflecting electrode 28 for X direction is made inoperative by grounding or removing it.

When the count value of the up/down counter 31 reaches a saturated value, the counter 31 outputs a carry signal (or single-scanning end signal) 31A. Upon reception of the carry signal 31A, a gate circuit 36 sends a state signal 36A to the gate circuit 30. The gate circuit 30 inputs pulses 22A to a down-counter input terminal of the counter 31. Thereby, the saturated count value of the counter 31 is decremented one by one. When the count value of the counter 31 becomes zero, the counter 31 a borrow signal (or single-scanning end signal) 31B so that the gate circuit 36 and the gate circuit 30 operate to turn the counter 31 into a count-up condition. Thus, the scanning in the Y direction assumes a triangular scanning.

On the other hand, a gate circuit 44 inputs the carry signal 31A and the borrow signal 31B as an input pulse signal 36B to a clockwise-rotation input terminal (or counterclockwise-rotation input terminal) of a pulse motor power source 45. The pulse motor power source 45 supplies pulses 45A to an X-direction driving pulse motor 46 of a specimen moving device 11 which gives a small movement to a specimen. Thereby, the pulse motor 46 is rotated by a predetermined angle to cause a small movement of a specimen table 47.

A counter 40 counts the carry signal 31A and the borrow signal 31B which have been mentioned above. The count value of the counter 40 is converted into an analog signal by a D/A converter 41. An output signal 41A of the D/A converter 41 is set to a predetermined voltage value by a voltage setter 42 and is thereafter inputted to a comparator 43. The comparator 43 compares the output voltage value 42A of the voltage setter 42 and the output voltage value 33A of the voltage setter or Y-direction scanning width setting circuit 33 to so that a pulse 43A is outputted and sent to the gate circuit 44 when the voltage 42A becomes equal to the voltage 33A. Upon reception of the pulse 43A, the gate circuit 44 inputs the pulse 36B to a counterclockwise-rotation input terminal (or clockwise-rotation input terminal) of the pulse motor power source 45. Thereby, the direction of rotation of the pulse motor 46 is inverted so that the specimen table 47 is subjected to a small movement in a reverse direction.

In this manner, the specimen table 47 repeats a small reciprocating movement thereof with a predetermined scanning width.

As the result of the above-mentioned operation, the electrical scanning and the mechanical scanning are matched with each other, thereby permitting an analysis with a high sensitivity.

Figs. 6c and 6d show the intensities $I_2$ of secondary ions in the X and Y directions in the case where an object point slit, as shown in Fig. 6a, having a width of $S_0$ and a height of $h_0$ is used and the scanning in the X direction or the width direction of the object point slit coincident with the direction of mass dispersion of secondary ions by the mass spectrometer 10 is mechanically made by $L_X$ through the small movement of the specimen table while the scanning in the Y direction perpendicular to the X direction is electrically made by $L_Y$ through the deflection of the primary beam, as shown in Fig. 6b. Figs. 6c and 6d correspond to Figs. 2b and 2c, respectively. From Fig. 6c, it is obvious that the intensity of secondary ions in the mechanical scanning direction or the X direction is uniform. Also, it is obvious from the comparison of Figs. 6d and 2c that the intensity of secondary ions in the Y direction in the case of the embodiment of the present invention is substantially the same as that in the case of the prior art. Accordingly, according to the embodiment of the present invention, the intensity of secondary ions obtained in a specimen area of $L_X \times L_Y$ is substantially uniform.

Though explanation has been omitted, it is of course that the electronic aperture technique is applicable to the embodiment of the present invention.

It will be self-evident to those skilled in the art that various modifications and/or changes to the foregoing embodiment may be made without departing from the essence of the present invention. Therefore, it is to be understood that the scope of the present invention should not be limited to the embodiment disclosed herein.

## Claims

1. An ion mass-spectroscopic analysis method comprising the steps of:
bombarding a specimen (5) with a primary beam (2) to generate secondary ion (7) from said specimen;
mass-analyzing said secondary ions;
scanning said specimen with said primary beam in a first direction; and
moving said specimen in a second direction substantially perpendicular to said first direction, whereby said secondary ions are derived from a two-dimensional area of said specimen which is determined by the scanning and movement of said specimen.

2. An ion mass-spectroscopic analysis method comprising the steps of:
bombarding a specimen (5) with a primary beam (2) to generate secondary ions (7) from said specimen;
mass-analyzing said secondary ions; and
moving one of said specimen and said primary beam relative to the other thereof in a first direction and the other relative to the one in a second direction substantially perpendicular to said first direction, respectively, whereby said specimen is substantially two-dimensionally scanned with said primary beam.

3. An ion mass-spectroscopic analysis method comprising the steps of:
bombarding a specimen (5) with a primary beam (2) to generate secondary ions (7) from said specimen;
mass-analyzing said secondary ions;

repeatedly scanning said specimen with said primary beam in a first direction; and
moving said specimen in a second direction substantially perpendicular to said first direction each time the scanning of said specimen in said first direction is made.

4. An ion mass-spectroscopic analysis method comprising the steps of:
bombarding a specimen (5) with a primary beam (2) to generate secondary ions (7) from said specimen;
mass-dispersing said secondary ions;
detecting the dispersed secondary ions;
step-wise moving said specimen in a direction of mass dispersion of said secondary ions; and
moving said specimen with said primary beam in a direction substantially perpendicular to said direction of mass dispersion each time the step-wise movement of said specimen is made.

5. An ion mass-spectroscopic analysis method comprising the steps of:
bombarding a specimen (5) with a primary beam (2) to generate secondary ions (7) from said specimen;
focusing said secondary ions onto an object point slit (9) in a direction of width thereof;
mass-dispersing the focused secondary ions in the width direction of said object point slit;
step-wise moving said specimen in the width direction of said object point slit; and
scanning said specimen with said primary beam in a direction substantially perpendicular to the direction of step-wise movement of said specimen each time the step-wise movement of said specimen is made.

6. An ion mass-spectroscopic analysis apparatus comprising:
means (1) for bombarding a specimen (5) with a primary beam (2) to generate secondary ions (7) from said specimen;
means (10) for mass-analyzing said secondary ions; and
means (11, 12) for moving one of said specimen and said primary beam relative to the other thereof in a first direction and the other relative to the one in a second direction substantially perpendicular to said first direction, respectively, whereby said specimen is moved substantially two-dimensionally scanned with said primary beam.

7. An ion mass-spectroscopic analysis apparatus comprising:
means (1) for bombarding a specimen with a primary beam (2) to generate secondary ions (7) from said specimen;
means (10) for mass-dispersing said secondary ions;
means (10) for detecting the dispersed secondary ions;

means (11) for moving said specimen in a direction of mass dispersion of said secondary ions; and
means (12) for scanning said specimen with said primary beam in a direction substantially perpendicular to the direction of movement of said specimen in relation to the movement of said specimen.

8. An ion mass-spectroscopic analysis apparatus according to Claim 7, wherein said specimen moving means (11) is constructed to step-wise move said specimen (5) and said specimen scanning means (12) is constructed to scan said specimen with said primary beam (2) each time the step-wise movement of said specimen is made.

9. An ion mass-spectroscopic analysis apparatus according to Claim 8, further comprising an object point slit (9) disposed between said specimen (5) and said mass-dispersing means (10) and means for focusing the secondary ions (7) from said specimen onto said object point slit in said direction of mass dispersion, said object point slit having a width enough to limit the amount of secondary ions passed therethrough in said direction of mass dispersion.

10. An ion mass-spectroscopic analysis apparatus according to Claim 9, wherein said specimen scanning means (12) includes means (31) for generating a scanning end signal for each scanning of said specimen and said specimen moving means (11) is constructed to step-wise move said specimen (5) in accordance with said scanning end signal.

11. An ion mass-spectroscopic analysis apparatus according to Claim 10, further comprising means (33) for generating a signal corresponding to the width of scanning of said specimen (5), means (42) for generating a signal corresponding to the amount of movement of said specimen, and means (43) for comparing said signal corresponding to the width of scanning of said specimen and said signal corresponding to the amount of movement of said specimen to generate a signal for stopping the movement of said specimen when the width of scanning of said specimen and the amount of movement of said specimen become substantially equal to each other.

12. An ion mass-spectroscopic analysis apparatus according to Claim 11, further comprising means (44, 45, 46) for inverting the movement of said specimen (5) on the basis of said signal for stopping the movement of said specimen.

90100644.3

F I G. 1a

F I G. 1b

F I G. 2a   F I G. 2b   F I G. 2c

# F I G. 3

# F I G. 6a  F I G. 6b  F I G. 6c  F I G. 6d

F I G. 4

# FIG. 5
## PRIOR ART

EP 0 378 077 A2